# EUROPEAN PATENT SPECIFICATION

(11) **EP 3 241 923 B1**
(45) Date of publication and mention of the grant of the patent: **04.09.2019**
(21) Application number: 15875109.9
(22) Date of filing: 21.12.2015
(51) Int. Cl.: C23C 14/54, H01L 51/00, C23C 14/26, C23C 14/24

(54) **LINEAR EVAPORATION SOURCE**
LINEARE VERDAMPFUNGSQUELLE
SOURCE D'ÉVAPORATION LINÉAIRE

(30) Priority: 29.12.2014 CN 201410831691
(43) Date of publication of application: 08.11.2017
(73) Proprietor: Kunshan Go-Visionox Opto-Electronics Co., Ltd., KunShan City, Jiangsu 215300 (CN)
(72) Inventor: PENG, Chao-Chi, Kunshan Jiangsu 215300 (CN); ZHANG, Shenfu, Kunshan Jiangsu 215300 (CN)
(74) Representative: Hanna Moore + Curley
(86) International application number: PCT/CN2015/097995
(87) International publication number: WO 2016/107431

(56) References cited:
- EP-A2- 1 418 250
- WO-A1-2011/074551
- CN-A- 1 320 172
- CN-A- 1 320 172
- CN-A- 101 182 627
- CN-A- 101 331 801
- CN-A- 101 838 790
- CN-A- 104 099 571
- CN-A- 104 561 905
- JP-A- S60 162 771
- US-A1- 2005 011 443
- US-A1- 2013 302 520

## Description

### Technical Field

The present invention relates to an evaporation source, and particularly relates to a linear evaporation source which can ensure the uniformity of the thickness of a vapor deposition film.

### Background art

In the manufacturing process of OLED (Organic Light Emitting Diode), with the size of vapor deposition substrate bigger, in order to ensure the uniformity of the thickness of the vapor deposition film, and to improve material utilization, the evaporation sources used by vapor deposition equipment have been developed to linear sources from the original point sources.

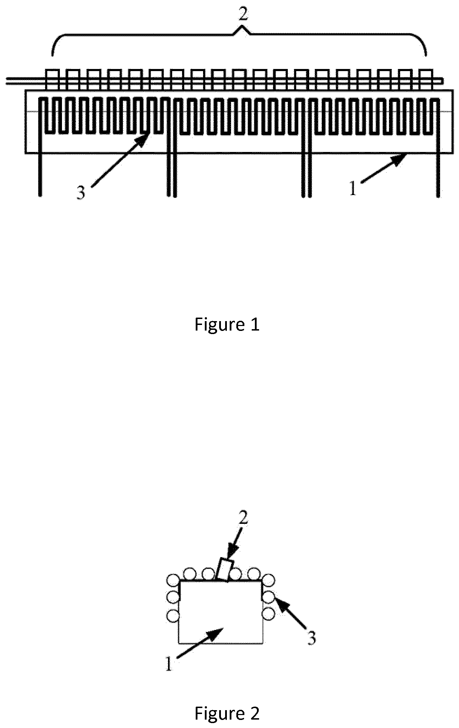

As shown in Figures 1 and 2, the current linear sources generally comprise a crucible 1 and more than one nozzle 2 above the crucible 1. Heating wires 3 are provided at the peripheries of the crucible 1 and the nozzles 2, inside which the vapor deposition material can become vapor, and then the vapor is sprayed out to the substrate to form a film after being uniform inside the crucible 1, by heating the crucible 1.

In current linear evaporation sources, because the heating of the vapor deposition material and the mixing of the vapor are simultaneously conducted in the crucible, the space for the mixing and uniformization of the vapor is limited, the material vapor trends to be sprayed from the nozzles before becoming uniform, which in turn results in the degrading of the uniformity of the thickness of the vapor deposition film. Especially for the crucibles just filled with the material, the space that can be used for the material vapor to equilibrium the pressure is more limited, which has greater influence on the uniformity of the thickness of the vapor deposition film. Furthermore, the heating wires of the current evaporation sources are sectional heating, which is a complex heating mode.

In the prior art, a processing system for depositing a plurality of source materials on a substrate is disclosed by US20130302520A1, in which the processing system includes a first thermal evaporation source that can evaporate a first source material to produce a first vapor, a second thermal evaporation source that can evaporate a second source material to produce a second vapor, a vapor mixing chamber configured to allow the first vapor and the second vapor to be mixed to produce a mixed vapor, and conduits that can separately transport the first vapor and the second vapor to the vapor mixing chamber, wherein the mixed vapor is directed toward a substrate to deposit a mixture of the first source material and the second source material on the substrate.

An evaporation equipment is disclosed by CN101838790A, wherein the evaporation device comprises: at least one evaporation source can increase the heat source material gas to generate the steam source material; one end of the evaporation source is connected with the box the box with linear guide outlet box of steam flow onto the substrate.

A vapor deposition apparatus is disclosed by WO2011074551A1, in which at least two vapor deposition sources for vaporizing different kinds of vapor deposition materials and a nozzle are provided. The nozzle has a space in which these vapor deposition materials can be mixed, each deposition material can be introduced from the at least two vapor deposition sources to the nozzles and a heater is provided in at least one of the nozzle and the pipe, wherein the nozzle or the evaporation source is provided in the nozzle or the evaporation source.

### Technical Problem

In view of that, the main purpose of the present invention is to provide a linear evaporation source which can make the thickness of the vapor deposition film to be uniform.

### Technical Solution

To achieve the above purpose, the present invention provides a linear evaporation source as disclosed in claim 1, comprising a heating chamber for containing a vapor deposition material, a mixing chamber located above the heating chamber and used to mix the vapor deposition material vapor, and a channel used to communicate the heating chamber and the mixing chamber; one end of the mixing chamber communicates with the heating chamber through the channel, and the other end is provided with a plurality of nozzles for spraying the vapor deposition material vapor; and heaters are provided at peripheries of the heating chamber, the mixing chamber, the channel and the nozzles.

The channel is composed of a plurality of channels.

The plurality of channels are evenly arranged between the heating chamber and the mixing chamber.

A middle plate that the vapor deposition material vapor can permeate is provided within the channel, and the middle plate is clamped at an inner wall of the channel.

The middle plate is provided with a plurality of through holes.

The shape of the edge of the middle plate is zigzag-shaped.

The channel is provided with a valve for controlling a flowing speed and a flow rate of the vapor deposition material vapor that flows through.

The heaters are heating wires evenly wound at the peripheries of the heating chamber, the mixing chamber, the channel or the nozzles.

The heating wires wound at the peripheries of the heating chamber, the mixing chamber, the channel and the nozzles are integrally formed.

The heaters provided at the peripheries of the heating chamber, the mixing chamber, the channel and the nozzles are heating plates.

### Advantageous effects

The linear evaporation source of the present invention can control the thickness of the vapor deposition film to have a better uniformity, because the heating of the vapor deposition material and the mixing of the material vapor are conducted in two independent spaces. The heaters provided at the peripheries of the heating chamber, the mixing chamber, the channel and the nozzles can heat simultaneously, without sectional heating, so as to simplify the heating mode.

### Brief Description of the Drawings

Figure 1 is the structural schematic diagram of a linear evaporation source in the prior art;
Figure 2 is the side view of Figure 1;
Figure 3 is the structural schematic diagram of the linear evaporation source according to the present invention;
Figure 4 is the side view of Figure 3;
Figure 5 is the structural schematic diagram of another embodiment of the linear evaporation source according to the present invention; and
Figure 6 is the side view of Figure 5.

### Detailed Description of Preferred Embodiments

In order to facilitate the further understanding of the structure and the effects of the present invention, a detailed description is made by referring to the drawings and the preferred embodiments.

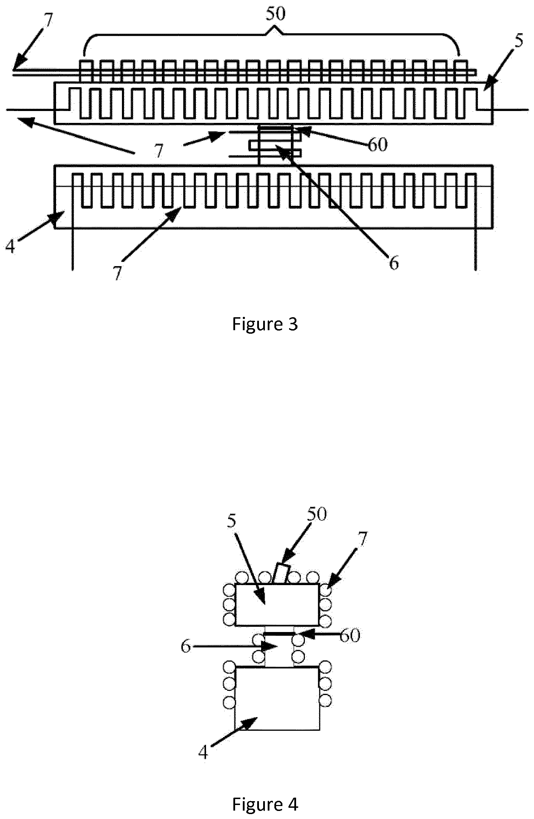

As shown in Figures 3 and 4, the linear evaporation source of the present invention comprises: a heating chamber 4, a mixing chamber 5 located above the heating chamber 4, and a channel 6 used to connect the heating chamber 4 and the mixing chamber 5, wherein one end of the mixing chamber 5 communicates with the heating chamber 4 through the channel 6, and the other end is provided with a plurality of nozzles 50. Heaters 7 are provided at the peripheries of the heating chamber 4, the mixing chamber 5, the channel 6 and the nozzles 50.

When the substrate is evaporation deposited by the linear evaporation source of the present invention, the vapor deposition material are placed inside the heating chamber 4, whose corresponding parts are heated by the heaters 7 provided at the peripheries of the heating chamber 4, the mixing chamber 5, the channel 6, and the nozzles 50. Then the vapor deposition material melt in the heating chamber 4 and vaporize into vapor deposition material vapor, or directly gasify into vapor deposition material vapor, which enters the mixing chamber 5 through the channel 6. Because the mixing of the vapor deposition material vapor is only done in the mixing chamber 5, the vapor deposition material vapor can balance the pressure in the mixing chamber 5, and the vapor deposition material vapor is sprayed from the nozzles 50 after homogeneous mixing, which can ensure forming the uniform thickness vapor deposition film on the substrate, so that vapor deposition on the substrate has been accomplished. The plurality of nozzles 50 of the present invention may be evenly arranged on the mixing chamber 5, so that the vapor deposition material vapor can be evenly sprayed from the nozzles 50, so as to form the vapor deposition film with more uniform thickness.

A middle plate 60 is disposed inside the channel 6 between the heating chamber 4 and the mixing chamber 5 of the present invention, wherein the middle plate 60 with more than one through holes is clamped on the inner wall of the channel 6, so that the middle plate 60 can prevent the unevaporated melted liquid from being sprayed into the mixing chamber 5 after the vapor deposition material have been melted in the heating chamber 4. Furthermore, before entering the mixing chamber 5, the vapor deposition material vapor inside the heating chamber 4 meets the middle plate 60, which has certain resistance on the vapor deposition material vapor, so that the vapor deposition material vapor can be evenly mixed primarily by the middle plate 60, and then evenly mixed in the mixing chamber 5 again, so as to further ensure the uniformity of the thickness of the vapor deposition film formed on the substrate. The shape of the edge of the middle plate 60 is zigzag-shaped in the present invention. The vapor deposition material vapor can enter the mixing chamber 5 through the zigzag-shaped interspace between the middle plate 60 and the inner wall of the channel 6. The middle plate 60 can prevent the unevaporated melted liquid from being sprayed into the mixing chamber 5, and can evenly mix the vapor deposition material vapor primarily before entering the mixing chamber 5.

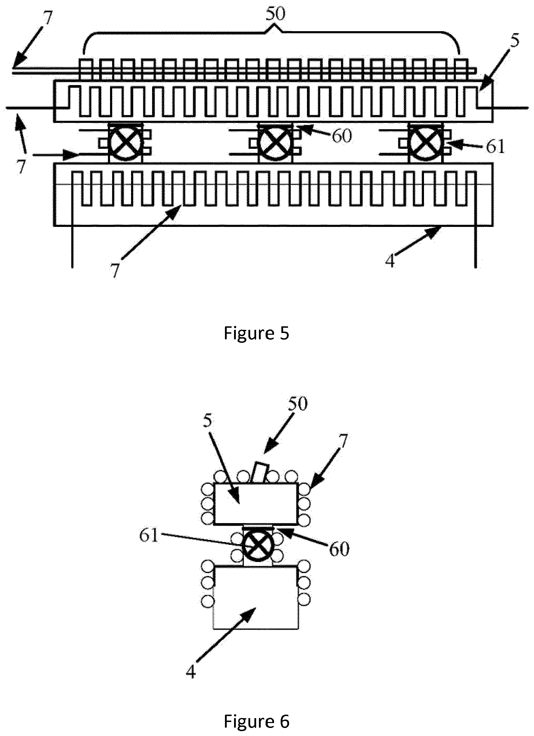

As shown in Figures 5 and 6, in the present invention there may be a plurality of channels 6 between the heating chamber 4 and the mixing chamber 5, which are evenly arranged between the heating chamber 4 and the mixing chamber 5. Each of the channels 6 may be provided with a valve 61, which can control the flowing speed and flow rate of the vapor deposition material vapor flowing through each of the channels 6, so that the vapor deposition material vapor in the mixing chamber 5 can become more uniformly. As an example, if more vapor deposition material is corresponding to a certain channel in the heating chamber 5, more vapor deposition material vapor can be generated, so that the flowing speed is quick and the flux is flow rate when the vapor deposition material vapor is flowing through the channel, then the valve on the channel can be controlled to control the flowing speed and flow rate of the vapor deposition material vapor flowing through the channel.

In the present invention, the heaters 7 may be heating wires evenly wound at the peripheries of the heating chamber 4, the mixing chamber 5, the channel 6 and the nozzles 50, so can evenly enough heat the vapor deposition material in the heating chamber 4 and the vapor deposition material vapor flowing through the channel 6, the mixing chamber 5 and the nozzles 50, so as to control the uniformity of the thickness of the vapor deposition film on the substrate. The heating wires wound at the peripheries of the heating chamber 4, the mixing chamber 5, the channel 6 and the nozzles 50 may be integrally formed. The heaters 7 of the present invention may also be heating plates for heating the corresponding heating chamber 4, mixing chamber 5, channel 6 and nozzles 50, whose temperatures can be adjusted according to actual circumstances.

The linear evaporation source of the present invention can control the thickness of the vapor deposition film to have a better uniformity, because the heating of the vapor deposition material and the mixing of the vapor deposition material vapor are conducted in two independent spaces of the heating chamber 4 and the mixing chamber 5. The heating wires of the present invention wound at the peripheries of the heating chamber 4, the mixing chamber 5, the channel 6 and the nozzles 50 may be integrally formed, without sectional heating, so as to simplify the heating mode.

The above description is only preferred embodiments of the present invention, and is not intended to limit the protection scope of the present invention.

## Claims

1. A linear evaporation source, **characterized by**: comprising: only one heating chamber (4) for containing a vapor deposition material, a mixing chamber (5) located above the heating chamber and used to mix the vapor deposition material vapor, and a channel (6) used to communicate the heating chamber and
the mixing chamber, wherein one end of the mixing chamber communicates with the heating chamber through the channel, and the other end is provided with a plurality of nozzles (50) for spraying the vapor deposition material vapor; and heaters (7) are provided at peripheries of the heating chamber (4), the mixing chamber (5), the channel (6) and the nozzles (50), **characterized in that** a middle plate (60) that the vapor deposition material vapor can permeate, is provided within the channel, the middle plate (60) is clamped at an inner wall of the channel (6) and is spaced apart from the interface of the heating chamber (4) and the interface of the mixing chamber (5), the position of middle plate (60) is closer to the mixing chamber (5) than the heating chamber (4), and the shape of the edge of the middle plate (60) is zigzag-shaped.

2. The linear evaporation source as claimed in claim 1, **characterized in that**: the channel is composed of a plurality of channels.

3. The linear evaporation source as claimed in claim 2, **characterized in that**: the plurality of channels are evenly arranged between the heating chamber and the mixing chamber.

4. The linear evaporation source as claimed in claim 1, **characterized in that**: the middle plate is provided with a plurality of through holes.

5. The linear evaporation source as claimed in any of claims 1-4, **characterized in that**: the channel is provided with a valve for controlling a flowing speed and a flow rate of the vapor deposition material vapor that flows through.

6. The linear evaporation source as claimed in claim 1, **characterized in that**: the heaters are heating wires evenly wound at the periphery of the heating chamber, the mixing chamber, the channel or the nozzles.

7. The linear evaporation source as claimed in claim 6, **characterized in that**: the heating wires wound at the peripheries of the heating chamber, the mixing chamber, the channel and the nozzles are integrally formed.

8. The linear evaporation source as claimed in claim 6, **characterized in that**: the heaters provided at the peripheries of the heating chamber, the mixing chamber, the channel and the nozzles are heating plates.

## Patentansprüche

1. Lineare Verdampfungsquelle, **dadurch gekennzeichnet, dass** sie Folgendes umfasst: nur eine Heizkammer (4) zum Enthalten eines Gasphasenabscheidungsmaterials, eine Mischkammer (5), die sich über der Heizkammer befindet und zum Mischen der Gasphase des Gasphasenabscheidungsmaterials verwendet wird, und einen Kanal (6), der zum Verbinden der Heizkammer mit der
Mischkammer verwendet wird, wobei ein Ende der Mischkammer mit der Heizkammer durch den Kanal in Verbindung steht und das andere Ende mit einer Vielzahl von Düsen (50) zum Sprühen der Gasphase des Gasphasenabscheidungsmaterials versehen ist; und Heizelemente (7) an den Rändern der Heizkammer (4), der Mischkammer (5), des Kanals (6) und der Düsen (50) vorgesehen sind, **dadurch gekennzeichnet, dass** innerhalb des Kanals eine Mittelplatte (60) vorgesehen ist, durch die die Gasphase des Gasphasenabscheidungsmaterials dringen kann, wobei die Mittelplatte (60) an einer Innenwand des Kanals (6) befestigt ist und sich in einem Abstand von der Grenzfläche zur Heizkammer (4) und der Grenzfläche zur Mischkammer (5) befindet, wobei die Position der Mittelplatte (60) näher an der Mischkammer (5) liegt als an der Heizkammer (4), und die Form der Kante der Mittelplatte (60) zickzackförmig ist.

2. Lineare Verdampfungsquelle nach Anspruch 1, **dadurch gekennzeichnet, dass** der Kanal aus einer Vielzahl von Kanälen besteht.

3. Lineare Verdampfungsquelle nach Anspruch 2, **dadurch gekennzeichnet, dass** die Vielzahl von Kanälen gleichmäßig zwischen der Heizkammer und der Mischkammer angeordnet ist.

4. Lineare Verdampfungsquelle nach Anspruch 1, **dadurch gekennzeichnet, dass** die Mittelplatte mit einer Vielzahl von Durchgangsbohrungen versehen ist.

5. Lineare Verdampfungsquelle nach einem der Ansprüche 1-4, **dadurch gekennzeichnet, dass** der Kanal mit einem Ventil zum Steuern einer Durchflussgeschwindigkeit und eines Durchflusses der durchströmenden Gasphase des Gasphasenabscheidungsmaterials versehen ist.

6. Lineare Verdampfungsquelle nach Anspruch 1, **dadurch gekennzeichnet, dass** die Heizelemente Heizdrähte sind, die gleichmäßig an den Rändern der Heizkammer, der Mischkammer, des Kanals oder der Düsen gewickelt sind.

7. Lineare Verdampfungsquelle nach Anspruch 6, **dadurch gekennzeichnet, dass** die Heizdrähte, die gleichmäßig an den Rändern der Heizkammer, der Mischkammer, des Kanals oder der Düsen gewickelt sind, einstückig ausgebildet sind.

8. Lineare Verdampfungsquelle nach Anspruch 6, **dadurch gekennzeichnet, dass** die Heizelemente, die an den Rändern der Heizkammer, der Mischkammer, des Kanals oder der Düsen vorgesehen sind, Heizplatten sind.

## Revendications

1. Source d'évaporation linéaire, **caractérisée par le fait qu'**elle comprend : une seule chambre de chauffage (4) pour contenir un matériau de dépôt sous vide, une chambre de mélange (5) située au-dessus de la chambre de chauffage et utilisée pour mélanger la vapeur de matériau de dépôt sous vide, et un canal (6) utilisé pour faire communiquer la chambre de chauffage et la chambre de mélange, une extrémité de la chambre de mélange communiquant avec la chambre de chauffage par l'intermédiaire du canal, et l'autre extrémité comportant une pluralité de buses (50) pour pulvériser la vapeur de matériau de dépôt sous vide ; et des éléments chauffants (7) étant disposés à des périphéries de la chambre de chauffage (4), de la chambre de mélange (5), du canal (6) et des buses (50), **caractérisée par le fait qu'**une plaque centrale (60), que la vapeur de matériau de dépôt sous vide peut traverser, est disposée à l'intérieur du canal, la plaque centrale (60) est serrée au niveau d'une paroi interne du canal (6) et est espacée de l'interface de la chambre de chauffage (4) et de l'interface de la chambre de mélange (5), la position de la plaque centrale (60) est plus proche de la chambre de mélange (5) que la chambre de chauffage (4), et la forme du bord de la plaque centrale (60) est en forme de zigzag.

2. Source d'évaporation linéaire selon la revendication 1, **caractérisée par le fait que** : le canal est composé d'une pluralité de canaux.

3. Source d'évaporation linéaire selon la revendication 2, **caractérisée par le fait que** : la pluralité de canaux sont disposés de manière uniforme entre la chambre de chauffage et la chambre de mélange.

4. Source d'évaporation linéaire selon la revendication 1, **caractérisée par le fait que** : la plaque centrale comporte une pluralité de trous traversants.

5. Source d'évaporation linéaire selon l'une quelconque des revendications 1 à 4, **caractérisée par le fait que** : le canal comporte une valve pour réguler une vitesse d'écoulement et un débit de la vapeur de matériau de dépôt sous vide qui s'écoule à travers.

6. Source d'évaporation linéaire selon la revendication 1, **caractérisée par le fait que** : les éléments chauffants sont des fils chauffants enroulés de manière uniforme à la périphérie de la chambre de chauffage, de la chambre de mélange, du canal ou des buses.

7. Source d'évaporation linéaire selon la revendication 6, **caractérisée par le fait que** : les fils chauffants enroulés aux périphéries de la chambre de chauffage, de la chambre de mélange, du canal et des buses sont formés d'un seul tenant.

8. Source d'évaporation linéaire selon la revendication 6, **caractérisée par le fait que** : les éléments chauffants disposés aux périphéries de la chambre de chauffage, de la chambre de mélange, du canal et des buses sont des plaques chauffantes.
